# FASCICULE DE BREVET EUROPEEN

(11) **EP 0 949 747 B1**
(45) Date de publication et mention de la délivrance du brevet: **05.02.2003**
(21) Numéro de dépôt: 98400841.7
(22) Date de dépôt: 07.04.1998
(51) Int. Cl.: H02K 37/14, H02K 21/14

(54) **Moteur polyphasé, notamment pour l'entraînement d'une aiguille d'un afficheur**
MEHRPHASENMOTOR, INSBESONDERE ZUM ANTRIEB EINES ZEIGERS EINER ANZEIGE
POLYPHASE MOTOR, IN PARTICULAR FOR DRIVING THE HAND OF A DISPLAY

(43) Date de publication de la demande: 13.10.1999
(73) Titulaire: MMT S.A., 1700 Fribourg (CH)
(72) Inventeur: Prudham, Daniel, 25220 Thise (FR)
(74) Mandataire: Breese, Pierre

(56) Documents cités:
- EP-B- 0 587 685
- DE-A- 1 488 074
- FR-A- 2 201 575
- FR-A- 2 742 940
- FR-A- 2 754 953
- GB-A- 855 468
- US-A- 5 418 588

## Description

La présente invention concerne un moteur électrique triphasé, notamment pour l'entraînement d'une aiguille d'un afficheur.

De tels moteurs sont par exemple décrits dans le brevet européen EP587685 de la demanderesse. Le but de l'invention est d'améliorer de tels moteurs de façon à augmenter le couple et à éliminer la pièce de fermeture de flux sans perdre l'avantage de la simplicité de la fabrication et les possibilités d'intégration des mécanismes associés tels les réducteurs.

Dans l'art antérieur, on connaît des moteurs triphasés comportant un rotor à 4 ou 5 paires de pôles et un stator avec respectivement 12 ou 15 pôles magnétiques. Par exemple, le brevet français N°FR 2201575 décrit un moteur comportant un rotor à 4 paires de pôles, un stator à 12 pôles magnétiques et 6 bobines électriques. Ces moteurs présentent l'inconvénient d'un couple sans courant trop important et pour cette raison ne conviennent pas pour certaines applications.

Une méthode de réduction des couples sans courant par inclinaison des pôles du rotor ou du stator est utilisée dans l'art antérieur mais nécessite un procédé coûteux de réalisation avec l'inconvénient de devoir être adaptée au cas par cas.

Une autre méthode de compensation des harmoniques entre phases ou à l'intérieur d'une même phase est décrite par le brevet N°FR 2742940 mais ne concerne que des moteurs diphasés comportant 8 pôles statoriques et 3 ou 5 paires de pôles au rotor. Cette méthode ne s'applique qu'aux harmoniques de rang 2 et 4 et ne s'applique donc pas aux moteurs triphasés qui présentent un couple sans courant constitué principalement d'une harmonique 6.

Un des buts de l'invention est de proposer une solution permettant de réduire le couple sans courant des moteurs triphasés sans aucun coût supplémentaire.

À cet effet, l'invention concerne un moteur triphasé selon la revendication 1.

Un tel moteur répond aux objectifs de l'invention grâce à un nombre accru de dents actives (9 au lieu de 4) et grâce à une réduction du trajet des lignes de champ dans l'air. La forme du circuit statorique en "W" assure la fermeture des lignes de champ entre le pôle central qui reçoit la bobine et les deux pôles adjacents.

Dans un mode de réalisation préférée, l'invention concerne un moteur de faible coût d'assemblage et de très faible épaisseur. Le stator présente trois circuits en "W" dont les jambes centrales sont écartées de 120°, et portent des bobines alimentées par des signaux déphasés de 120°.

Les moteurs pas-à-pas selon l'état de la technique présentent par ailleurs un déplacement saccadé, dû au fait qu'un pôle aimanté du rotor trouve une position d'équilibre privilégié lorsqu'il est placé en regard d'une dent statorique, ou lorsqu'une transition entre deux pôles magnétiques se trouve en regard d'une dent statorique. Le couple de détente constitue de ce fait une fonction périodique de la position angulaire dont la fréquence dépend du nombre de pôles magnétiques et du nombre de pôles statoriques. On a cherché dans l'état de la technique à "lisser" cette fonction en augmentant le nombre de pôles. Cela implique toutefois une plus grande complexité mécanique et un coût de fabrication et d'assemblage élevé.

Un deuxième but de la présente invention est de remédier à cet inconvénient en proposant une construction offrant, avec un nombre de pôles magnétiques et statorique raisonnable, une limitation sensible du couple de détente.

À cet effet, l'invention concerne un mode de réalisation mettant en oeuvre trois circuits en "W" formant ainsi un stator à 9 pôles. Les jambes centrales des circuits en "W" sont orientées radialement et forment entre-elles des angles de 120°. Elles portent des bobines alimentées par trois signaux de type sin ρ, sin ρ+120°, sin ρ-120°.

Cette structure permet de réduire considérablement le couple de détente par annulation des harmoniques 2, 4 et 6 de la fonction (couple de détente, position angulaire). Le moteur selon l'invention présente ainsi un déplacement non saccadé malgré le nombre réduit de pôles magnétiques ou statoriques.

Avantageusement, le stator est constitué par une pièce unique découpée pour présenter deux paires de circuits en "W" diamétralement opposés dont les extrémités polaires sont équidistantes angulairement. Avantageusement, les jambes recevant les bobines électriques s'étendent dans une partie centrale évidée dont les dimensions permettent l'introduction d'une bobine électrique dans le plan des jambes et la mise en place autour de la jambe correspondante par translation.

Les bobines peuvent être ainsi fabriquées séparément selon des procédés plus économiques que le bobinage autour d'une partie statorique complexes, et être ensuite enfilées sur les jambes correspondantes.

Le stator peut être fabriqué selon des procédés simples et peu coûteux. Le fait qu'il soit formé par une seule pièce découpée évite les problèmes de précision de l'assemblage et de dérèglement.

De préférence, les jambes portant les bobines électriques s'étendent radialement. Selon un mode de réalisation particulier, le stator est constitué par un empilement de tôles fines. Ce mode de réalisation permet d'utiliser des techniques d'usinage peu coûteuses pour la découpe du stator, et d'améliorer les performances magnétiques du stator.

De préférence, l'extrémité frontale de l'épanouissement polaire est située dans le plan de la face frontale intérieur de la bobine.

Selon une variante de réalisation particulière, le rotor est formé par un aimant aimanté suivant une direction perpendiculaire au plan du stator et placés entre deux disques crantés présentant des dents décalées.

Selon une variante particulière de réalisation, le moteur polyphasé présente une pièce auxiliaire de fermeture de flux, avantageusement une pièce de fermeture du flux magnétique en un matériau doux coaxial avec le rotor.

Selon un premier mode de réalisation, la pièce de fermeture du flux magnétique est une pièce cylindrique en forme de bague. Cette bague peut être fixe par rapport au rotor, ou solidaire de l'aimant.

Selon un deuxième mode de réalisation, la pièce de fermeture du flux magnétique est une pièce cylindrique en forme de bague présentant des cannelures formant des dents placées en regard des dents statoriques.

L'invention sera mieux comprise à la lecture de la description qui suit, faisant référence aux dessins annexés où :
- les figures 1 et 2 représentent des vues respectivement de dessus et en coupe transversale d'un moteur selon l'invention ;
- la figure 3 représente une vue en coupe transversale d'un rotor pour le moteur selon l'invention.

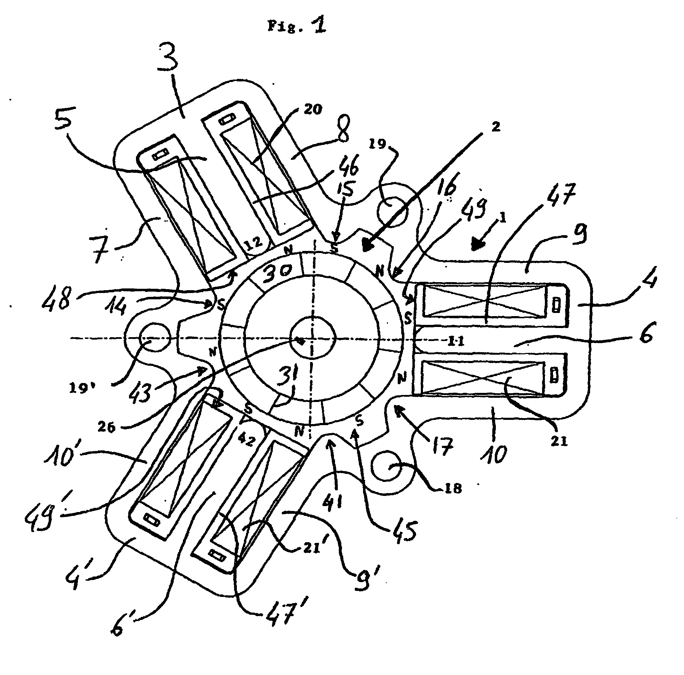

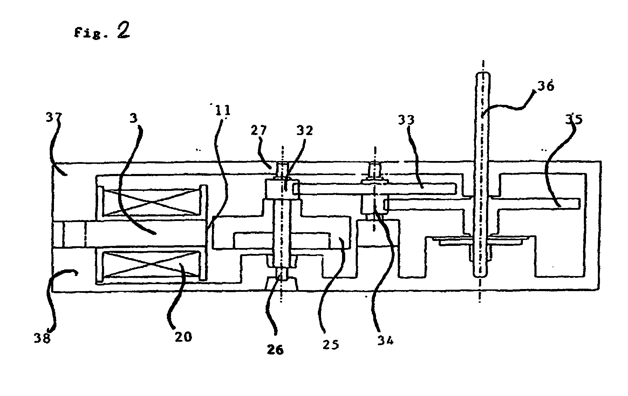

Les figures 1 et 2 représentent des vues respectivement de dessus et en coupe transversale d'un moteur selon l'invention. Le moteur comporte un stator (1) est un rotor (2).

Le stator (1) est réalisé par découpage dans une feuille métallique d'une épaisseur de 2 millimètres, ou par empilement de plusieurs feuilles métalliques en un matériau magnétiquement doux. Le stator présente trois circuits en "W" (3, 4 et 4') présentant chacun une jambe médiane (5, 6) et deux jambes latérales (7, 8 et 9, 10). Les jambes médianes (5, 6) se terminent chacune par un épanouissement polaire respectivement (11, 12). Les jambes latérales présentent également des épanouissements polaires (14 à 17). Le stator (1) présente par ailleurs des trous (18, 19) pour le passage d'organe de fixation sur un support, par exemple de vis ou des rivets.

Les jambes médianes (5, 6 et 6') reçoivent des bobines électriques respectivement (20, 21 et 21'). Ces trois jambes (5, 6 et 6') sont orientées radialement. Les bobines sont alimentées avec des signaux électriques déphasés, par exemple un signal Usin(ρt), un signal Usin(ρt + 120°) et un signal Usin'(ρt-120°).

Le rotor (2) est formé par une pièce cylindrique (25) aimantée radialement pour présenter alternativement, à la surface extérieure (26), des pôles SUD et des pôles NORD. La partie aimantée peut être formée par l'association de 10 aimants minces en forme de tuiles collées sur un noyau cylindrique ou encore par l'aimantation de secteurs tubulaires.

Une autre solution encore consiste à aimanter en surface une pièce cylindrique selon des festons de façon à ce que deux pôles opposés soient formés par des éléments de surface périphérique adjacents, reliés par une zone en arc de cercle pénétrant à l'intérieur de l'élément cylindrique.

Le rotor (2) est supporté de manière connue par des pivots (26, 27) visibles sur la figure 2.

Les jambes médianes (5, 6 et 6') des deux phases opposées supportant les bobines électriques (20, 21 et 21') sont orientées de manière à ce que, lorsqu'un pôle magnétique (30) est en regard de l'un des épanouissements polaires (12), l'autre épanouissement polaire (42) est en regard d'une transition (31).

Le rotor (2) présente une bague crantée (32) propre à entraîner un train d'engrenage (33 à 35). Ce train d'engrenage transmet le mouvement rotatif à un arbre de sortie (36).

Le stator (1) est logé dans l'exemple décrit dans un boîtier formé de deux coques (37, 38) complémentaires assurant par ailleurs le maintien des axes du train d'engrenage (32 à 35).

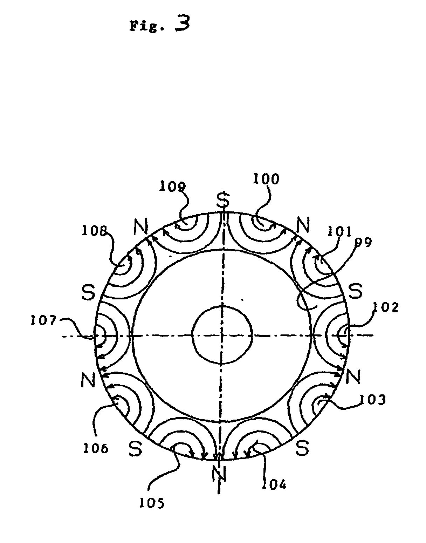

La partie centrale (45) du stator (1) est évidée. L'introduction des bobines électriques (20, 21 et 21') s'effectue par un premier déplacement selon une direction perpendiculaire au plan du stator correspondant au plan de la figure 3, puis par déplacement par translation radiale pour faire glisser la bobine autour de l'une des jambes médianes (5, 6 et 6'). Cette opération est bien sur réalisée avant que le rotor (2) ne soit mis en place. La bobine peut être formée sur un noyau (46, 47 et 47') dont la section est complémentaire de celle des jambes (5, 6 et 6') et présentant une face frontale (48, 49) venant affleurer l'extrémité de l'épanouissement polaire (11, 12, 42, 49) de la jambe (5, 6) correspondante.

La figure 3 représente une vue en coupe transversale d'une autre variante de rotor. Le rotor comporte une bague (99) en un matériau magnétique doux, présentant dix zones (100 à 109) aimantées en festons de façon à présenter des pôles alternés à la surface de ladite bague (99).

## Revendications

1. Moteur triphasé formé par une partie statorique (1) excitée par des bobines électriques et par un rotor aimanté (2), le rotor (2) présentant N paires de pôles aimantés radialement en sens alternés, N étant égale à 4 ou à 5, **caractérisé en ce que** la partie statorique (1) présente neuf pôles magnétiques et trois circuits en forme de "W" (3) assurant la fermeture des lignes de champ entre le pôle central et les deux pôles adjacents d'un circuit en "W" et comportant chacun une bobine électrique (21) entourant la jambe centrale (11), lesdits circuits en "W" (3) étant disposés de façon à ce que leurs jambes centrales soient écartées d'un angle égal à 120° et à ce que lorsque l'une des jambes centrales se trouve en face d'une transition magnétique, les autres jambes centrales se trouvent sensiblement en face d'un pôle magnétique, les épanouissements polaires des jambes centrales de deux circuits en "W" (3) étant écartées angulairement d'un angle électrique égal à 120°.

2. Moteur polyphasé selon la revendication 1 **caractérisé en ce que** les bobines électriques sont alimentées par des signaux déphasés de 120°.

3. Moteur polyphasé selon l'une au moins des revendications précédentes **caractérisé en ce que** le stator est constitué par une pièce unique découpée pour présenter trois circuits en "W".

4. Moteur polyphasé selon la revendication 3 **caractérisé en ce que** le stator (1) présente une partie centrale évidée dont les dimensions permettent l'introduction d'une bobine électrique dans le plan des jambes et la mise en place autour de la jambe correspondante par translation.

5. Moteur polyphasé selon l'une quelconque des revendications précédentes **caractérisé en ce que** les jambes portant les bobines électriques s'étendent radialement.

6. Moteur polyphasé selon l'une quelconque des revendications précédentes **caractérisé en ce que** le stator est constitué par un empilement de tôles fines.

7. Moteur polyphasé selon l'une quelconque des revendications précédentes **caractérisé en ce que** l'extrémité frontale de l'épanouissement polaire est située dans le plan de la face frontale intérieure de la bobine.

8. Moteur polyphasé selon l'une quelconque des revendications précédentes **caractérisé en ce que** le rotor (2) est formé par un aimant aimanté suivant une direction perpendiculaire au plan du stator (1) et placé entre deux disques crantés (81, 82) présentant des dents décalées.

9. Moteur polyphasé selon l'une quelconque des revendications précédentes **caractérisé en ce que** le rotor (2) est formée par une bague (99) aimantée en festons.

10. Moteur polyphasé selon l'une quelconque des revendications précédentes **caractérisé en ce que** le rotor présente une pièce auxiliaire de fermeture de flux.

11. Moteur polyphasé selon la revendication 10 **caractérisé en ce que** la pièce de fermeture du flux magnétique est une pièce cylindrique en forme de bague présentant des cannelures formant des dents placées en regard des dents statoriques.

12. Moteur triphasé selon la revendication 1 **caractérisé en ce que** le rotor (2) présente quatre paires de pôles.

## Patentansprüche

1. Dreiphasenwechselstrommotor, bestehend aus einem Statorteil (1), der von elektrischen Spulen und von einem magnetisierten Rotor (2) erregt wird, wobei der Rotor (2) N Polpaare aufweist, die radial in abwechselnder Richtung magnetisiert sind, wobei N gleich 4 oder 5 ist, **dadurch gekennzeichnet, dass** der Statorteil (1) neun Magnetpole und drei W-förmige Stromkreise aufweist, welche die Schließung der Feldlinien zwischen dem Mittelpol und den beiden nebeneinander liegenden Polen eines W-förmigen Stromkreises gewährleisten und jeweils eine elektrische Spule (21) umfassen, welche den Mittelschenkel (11) umgibt, wobei die W-förmigen Stromkreise (3) derart angeordnet sind, dass ihre Mittelschenkel in einem Winkel von 120° gespreizt sind, und dass, wenn sich einer der Mittelschenkel einem magnetischen Übergang gegenüber befindet, die anderen Mittelschenkel sich im Wesentlichen einem Magnetpol gegenüber befinden, wobei die Polausweitungen der Mittelschenkel von zwei W-förmigen Stromkreisen (3) winkelig um einen elektrischen Winkel von 120° gespreizt sind.

2. Mehrphasenmotor gemäß Anspruch 1, **dadurch gekennzeichnet, dass** die elektrischen Spulen von um 120° phasenverschobene Signalen gespeist werden.

3. Mehrphasenmotor gemäß mindestens einem der vorhergehenden Ansprüche, **dadurch gekennzeichnet, dass** der Stator aus einem einzigen Stück besteht, das ausgeschnitten wird, um drei W-förmige Stromkreise aufzuweisen.

4. Mehrphasenmotor gemäß Anspruch 3, **dadurch gekennzeichnet, dass** der Stator (1) einen ausgehöhlten Mittelteil aufweist, dessen Abmessungen die Einführung einer elektrischen Spule in die Ebene der Schenkel und durch Translation den Einsatz um den entsprechenden Schenkel herum ermöglichen.

5. Mehrphasenmotor gemäß einem der vorhergehenden Ansprüche, **dadurch gekennzeichnet, dass** sich die Schenkel, welche die elektrischen Spulen tragen, radial erstrecken.

6. Mehrphasenmotor gemäß einem der vorhergehenden Ansprüche, **dadurch gekennzeichnet, dass** der Stator aus einem Stapel dünner Bleche besteht.

7. Mehrphasenmotor gemäß einem der vorhergehenden Ansprüche, **dadurch gekennzeichnet, dass** das Vorderende der Polausweitung sich in der Ebene der inneren Vorderseite der Spule befindet.

8. Mehrphasenmotor gemäß einem der vorhergehenden Ansprüche, **dadurch gekennzeichnet, dass** der Rotor (2) durch einen Magnet gebildet wird, der in einer Richtung senkrecht zu der Statorebene (1) magnetisiert und zwischen zwei Rastenscheiben (81, 82), die versetzte Zähne aufweisen, angeordnet ist.

9. Mehrphasenmotor gemäß einem der vorhergehenden Ansprüche, **dadurch gekennzeichnet, dass** der Rotor (2) aus einem geschweift magnetisierten Ring (99) gebildet wird.

10. Mehrphasenmotor gemäß einem der vorhergehenden Ansprüche, **dadurch gekennzeichnet, dass** der Rotor ein Hilfsstück zum Schließen des Flusses aufweist.

11. Mehrphasenmotor gemäß Anspruch 10, **dadurch gekennzeichnet, dass** das Stück zum Schließen des Magnetflusses ein ringförmiges Zylinderstück ist, das Rillen aufweist, die Zähne bilden, die gegenüber von Statorzähnen angeordnet werden.

12. Dreiphasenwechselstrommotor gemäß Anspruch 1, **dadurch gekennzeichnet, dass** der Rotor (2) vier Polpaare aufweist.

## Claims

1. Three-phase motor formed by a stator part (1) excited by electric bobbins and by a magnetised rotor (2), said rotor (2) having N pairs of poles magnetized radially in alternate directions, N being equal to 4 or to 5, **characterised in that** the stator part (1) has nine magnetic poles and three circuits in "W" shape (3) ensuring closure of the field lines between the central pole and the two adjacent poles of a circuit in "W" shape and each comprising an electric bobbin (21) surrounding the central strut (11), said "W" shape circuits (3) being arranged in such a way that their central struts are separated by an angle equal to 120° and **in that** when one of the central struts is positioned in front of a magnetic transition, the other central struts are closely opposite to a magnetic pole, the pole shoes of the central struts of two "W" circuits (3) being separated angularly by an electrical angle equal to 120°.

2. Polyphase motor according to claim 1, **characterised in that** the electric bobbins are supplied by signals shifted by 120°.

3. Polyphase motor according to at least one of the preceding claims **characterised in that** the stator is constituted of a single piece cut out to provide three "W" circuits.

4. Polyphase motor according to claim 3 **characterised in that** the stator (1) has an empty central part with dimensions allowing introduction of an electric bobbin in the plane of the struts and set around the corresponding strut by translation.

5. Polyphase motor according to any one of the preceding claims, **characterised in that** the struts carrying the electric bobbins extend radially.

6. Polyphase motor according to any one of the preceding claims, **characterised in that** the stator is constituted of a stack of thin metal sheets.

7. Polyphase motor according to any one of the preceding claims, **characterised in that** the front end of the pole shoe is located in the plane of the internal front face of the bobbin.

8. Polyphase motor according to any one of the preceding claims, **characterised in that** the rotor (2) is formed by a magnet magnetised along a direction perpendicular to the plane of the stator (1) and placed between two notched discs (81, 82) with offset teeth.

9. Polyphase motor according to any one of the preceding claims, **characterised in that** the rotor (2) is formed by a festoon magnetised ring (99.

10. Polyphase motor according to any one of the preceding claims, **characterised in that** the rotor has an auxiliary flux closure part.

11. Polyphase motor according to claim 10, **characterised in that** the magnetic flux closure part is a cylindrical part in the shape of a ring with serrations forming teeth placed opposite the stator teeth.

12. Three-phase motor according to claim 1, **characterised in that** the rotor (2) has four pairs of poles.
